Europäisches Patentamt

European Patent Office

Office européen des brevets

(19)

(11) **EP 1 496 397 A1**

(12) **EUROPEAN PATENT APPLICATION**

(43) Date of publication:
**12.01.2005  Bulletin 2005/02**

(51) Int Cl.7: **G03F 7/20**

(21) Application number: **03077204.0**

(22) Date of filing: **11.07.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(71) Applicant: **ASML Netherlands B.V.**
**5504 DR Veldhoven (NL)**

(72) Inventor: **The designation of the inventor has not yet been filed**

(74) Representative: **van Westenbrugge, Andries et al**
**Nederlandsch Octrooibureau**
**Postbus 29720**
**2502 LS Den Haag (NL)**

(54) **Method and system for feedforward overlay correction of pattern induced distortion and displacement, and lithographic projection apparatus using such a method and system**

(57)    A method for modifying an aerial image during an imaging process, where a pattern is arranged on a mask for imaging by a projection system on a surface. The aerial image is formed by a portion of the projection system. This portion of the projection system has an imaging quality which is described by a set of imaging quality parameters.

The projection system can adjust the aerial image by image adjustment parameters for the portion of the projection system by the following steps:

- determining an ideal aerial image for the pattern;
- determining a simulated distorted aerial image for the pattern based on the set of imaging quality parameters;
- determining a deviation between the simulated distorted image and the ideal image, and
- adapting the image adjustment parameters during the imaging process to minimise the deviation between the simulated distorted image and the ideal image.

*Fig 1*

**Description**

Field of the invention

The present invention relates to a method for modifying an aerial image of a pattern during an imaging process as defined in the preamble of claim 1. Moreover, the present invention relates to a system for modifying an aerial image of a pattern during an imaging process. Further, the present invention relates to a lithographic projection apparatus using such a method and system.

Background of the invention

The present invention finds an application in the field of lithographic projection apparatus that encompass a radiation system for supplying a projection beam of radiation, a support structure for supporting patterning means, which serves to pattern the projection beam according to a desired pattern, a substrate table for holding a substrate; and, a projection system for projecting the patterned beam onto a target portion of the substrate.

The term "patterning means" as employed here should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmission mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;

- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as non-diffracted light. Using an appropriate filter, the said non-diffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and

- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as set forth here above.

Lithographic projection apparatus can be used, for example, in the manufacture of integrated circuits (ICs). In that case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemical-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens".

Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The person skilled in the art will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and " projection beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm).

For lithographic processing, the location of patterns in subsequent layers on the wafer should be as precise as possible for a correct definition of device features on the substrate, which features all should have sizes within specified tolerances. The overlay should be within well-defined tolerances for creating functional devices. To this end, the lithographic projection apparatus comprises an overlay measurement module which provides for determining the overlay of a pattern on the substrate with a mask pattern as defined in a resist layer on top of the pattern.

The overlay system typically performs the measurement by optical means. The position of the mask pattern relative to the position of the pattern on the substrate is determined by measuring an optical response from an optical marker which is illuminated by an optical source. The signal generated by the optical marker is measured by a sensor arrangement. Using the output of the sensors the overlay can be derived.

Optical markers are used during microelectronic device processing (or IC processing) along the full manufacturing line. During the front end of line (FEOL), markers are used for overlay during manufacturing of transistor structures. At a later stage during the back end of line (BEOL), markers are needed for overlay of metallisation structures, e.g. connect lines, and vias. It is noted that in both cases the integrity of the markers must be sufficient to meet the required accuracy of overlay.

In the prior art marker structures for overlay control are present in some area(s) of a substrate to allow for controlling the overlay of a mask pattern in a resist layer (after exposure and development) with further pattern already present on the substrate. A well-known structure for overlay control is a so-called overlay metrology target, which in this example, comprises a first structure consisting of 4 rectangular blocks as constituent parts arranged with their length along one of the sides of an imaginary square, and a second structure similar to, but smaller than, the first structure. To determine the overlay of patterns in two successive layers, one of the first and second structures is defined in the pattern in the first successive layer, the other one of the first and second structures is defined in the pattern in the resist layer for the second successive layer. In use, for both first and second structure the position (e.g., the gravity centre) is determined by a detection of the edges of the respective rectangular blocks within the first and second structures. From the difference in gravity centre position of the respective first and second structure, the overlay of the two structures is determined. It is noted that in the prior art other overlay metrology targets such as a box-in-box target are also known.

In the prior art it is recognised that for proper processing the constituent parts of a marker structure which typically consists of the same material as (parts of) device features, should preferably have dimensions similar to dimensions of features of micro-electronic devices to avoid size-induced deviations during processing of integrated circuits, due to, for example, a micro-loading effect during a reactive ion etching process which may occur at device structures in the vicinity of a large marker area or due to size dependency of chemical-mechanical polishing (CMP) of structures.

US 5,917,205 discloses photo-lithographic alignment marks based on circuit pattern features. Alignment marker structures are mimicked by a plurality of sub-elements which are ordered in such a way that their envelope corresponds to the marker structure. Further, each sub-element has dimensions comparable to a critical feature size of a microelectronic device. Basically, the solution to marker size induced processing deviations is by "chopping up" a large marker into many small-sized sub-elements which resemble features of a device (or "product").

Although the processing deviations of the structures lessen and wafer quality improves, it is noted that overlay of features depends also on the quality of the projection system. The projection system comprises lenses which each may have aberrations. Such aberrations are typically small and are reduced with each new lens design, but since the device features to be imaged are becoming smaller with each new device generation, the relative influence of the optical aberrations is also increasing with each new device generation.

Moreover, the distortion is dependent on the actual optical path that a light signal passing through an opening in a mask pattern (relating to a given feature), traverses in the projection system before impinging on the (resist coated) substrate.

Due to the dependency on the actually traversed optical path, the observed distortion of imaged features varies with the position of the features on the mask and is generally known as pattern-induced distortion.

Furthermore, the density of a pattern of small features also influences the amount of pattern induced distortion. For a dense part in the centre of a mask pattern the distortion will differ from a distortion caused by a less dense part at the edge of the mask pattern. By consequence, the distortion measured for an overlay structure, e.g., an overlay target at the outer periphery of a mask pattern will differ from the distortion within the centre part of the mask pattern.

Typically, the centre of the mask pattern will comprise the devices or products which are relevant to the semiconductor device manufacturer. Disadvantageously, the overlay control is thus not very effective: the devices will have a distortion different from the distortion measured at the location of the overlay.

Summary of the invention

It is an object of the present invention to provide a method to correct for overlay errors which are caused by pattern induced distortion in a projection system of a lithographic projection apparatus.

This object is achieved by a method as defined in the preamble of claim 1, characterised in that the projection system is arranged for adjusting a geometry of the aerial image by image adjustment parameters for the portion of the projection system,

and the method comprises:

- determining an ideal aerial image for the pattern;
- determining a simulated distorted aerial image for the pattern based on the imaging quality parameters;
- determining a deviation between the simulated distorted image and the ideal image;
- adapting the image adjustment parameters during the imaging process to minimise the deviation between the simulated distorted image and the ideal image.

Advantageously, the method according to the present invention allows the use of standard overlay metrology targets on a mask pattern in combination with product features with dimensions much smaller than the dimensions of the features of the overlay metrology target. The method uses information on the aberrations of the projection system to adapt the settings of the projection system in such a way that distortions of an image are counteracted. Both low-order aberrations which cause image distortion effects that are independent of the optical path in the lens system to form the image, and high-order lens aberrations which relate to distortion effects that depend on the optical path actually used in the lens system, can be corrected.

Since standard overlay metrology targets will display a different distortion than product features with much smaller dimensions, due to the use of different optical path and different region of the projection lens system, the method is advantageously capable to correct the respective distortion of standard metrology target image and product feature image simultaneously.

Moreover, the present invention provides a system which is arranged to carry out the method of the present invention.

Also, the present invention provides a computer program product capable of carrying out the method of the present invention.

Furthermore, the present invention provides a data carrier with a computer program product as described above.

Finally, it is an object of the present invention to provide a lithographic projection apparatus which is capable of using the method and system as described above.

Brief description of drawings

Below, the invention will be explained with reference to some drawings, which are intended for illustration purposes only and not to limit the scope of protection as defined in the accompanying claims.

Figure 1 depicts a lithographic projection apparatus comprising at least one marker structure in accordance with the present invention;

Figure 2 shows schematically a computer arrangement as used in the system according to the present invention;

Figure 3 shows schematically a projection system;

Figure 4 shows an exemplary map for total lens distortion of a projection system;

Figure 5 shows exemplary pattern induced distortion data for product and overlay metrology features as measured as a function of slit co-ordinate;

Figure 6 shows the distortion data of Figure 5 for product and overlay metrology features after applying a metrology-based correction.

Description of embodiments

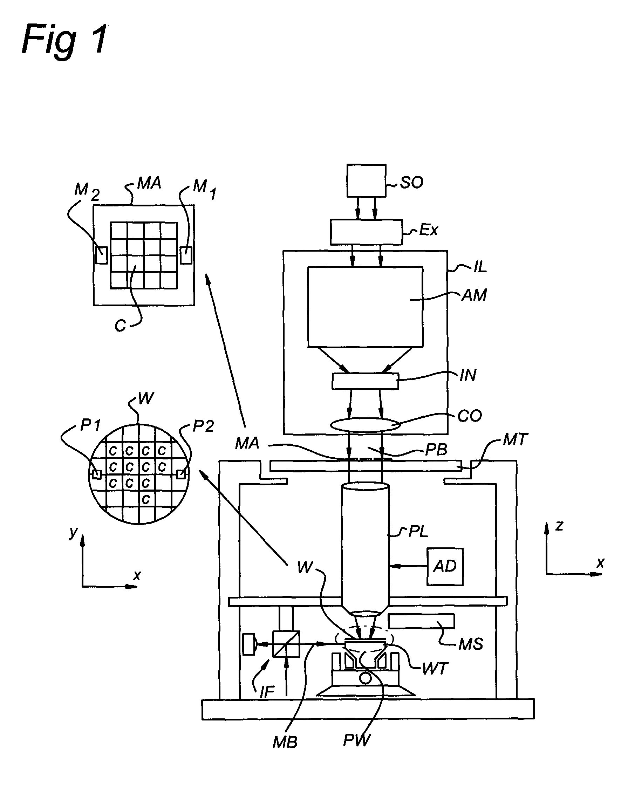

Figure 1 schematically depicts a lithographic projection apparatus 1 comprising at least one marker structure according to a particular embodiment of the invention. The apparatus comprises:

- a radiation system Ex, IL, for supplying a projection beam PB of radiation (e.g. UV radiation). In this particular case, the radiation system also comprises a radiation source SO;
- a first object table (mask table) MT provided with a mask holder for holding a mask MA (e.g. a reticle), and connected to first positioning means (not shown) for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

The projection system PL is provided with an actuating device AD for adapting the optical settings of the system. The operation of adapting optical settings will be explained later in more detail.

As depicted here, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source SO (e.g. a mercury lamp or an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source SO may be within the housing of the lithographic projection apparatus (as is often the case when the source SO is a mercury lamp, for example), but that it may also be remote from the lithographic projection apparatus, the radiation beam which it produces being led into the apparatus (e.g. with the aid of suitable directing mirrors); this latter scenario is often the case when the source SO is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW and interferometric measuring means, the substrate table WT can be moved accurately, e.g. so as to position different target portions C in the path of the beam PB. Similarly, the first positioning means (acting on mask table MT) can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the X and/or Y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the Y-direction) with a speed v, so that the projection beam PB is caused to scan over a mask image; concurrently, the substrate table WT is simultaneously moved in the same or opposite direction at a speed $V = M v$, in which M is the magnification of the lens PL (typically, M = 1/4 or 1/5). In this manner, a relatively large target portion C can be exposed, without having to compromise on resolution.

The interferometric measuring means typically can comprise a light source, such as a laser (not shown), and one or more interferometers for determining some information (e.g., position, alignment, etc.) regarding an object to be measured, such as a substrate or a stage. In Figure 1, for example, one interferometer IF is schematically depicted. The light source (laser) produces a metrology beam MB which is routed to the interferometer IF by one or more beam manipulators. In case more than one interferometer is present, the metrology beam is shared between them, by using optics that split the metrology beam in various separate beams for each interferometer.

A substrate alignment system MS for alignment of a substrate on table WT with a mask on mask table T, is schematically shown at an exemplary location close to table WT, and comprises at least one light source which generates a light beam aimed at a marker structure on the substrate and at least one sensor device which detects an optical signal from that marker structure. It is noted that the location of the substrate alignment system MS depends on design conditions which may vary with the actual type of lithographic projection apparatus.

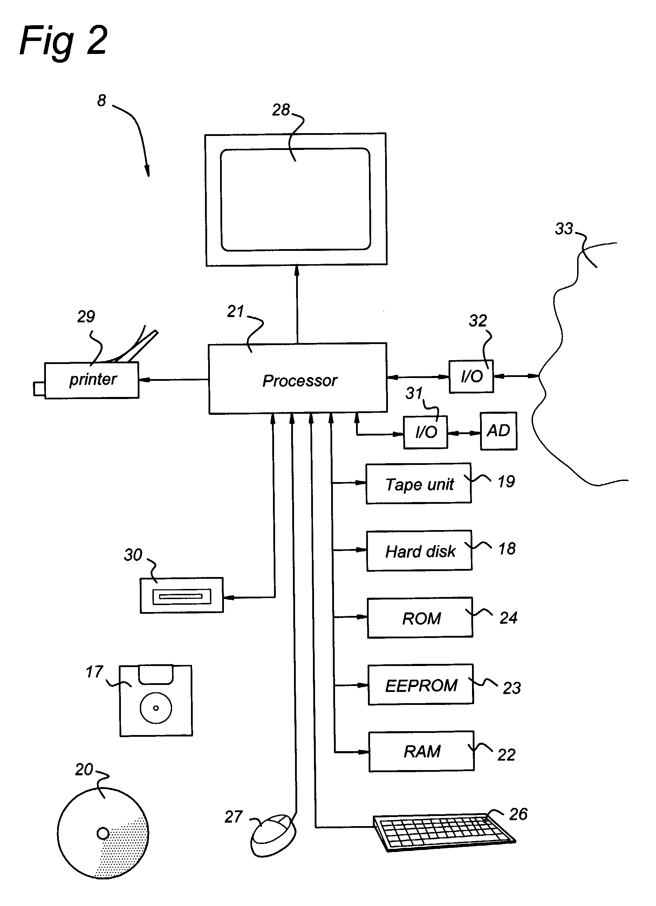

Further, the lithographic projection apparatus comprises an electronic control system which is capable of controlling and adjusting machine parameters during execution of an imaging and exposure process. An exemplary electronic control system is schematically illustrated with reference to Figure 2.

Figure 2 shows schematically a computer arrangement 8 as used in the system according to the present invention.

It is noted that a lithographic projection apparatus comprises sophisticated computing resources for controlling functions of the lithographic projection apparatus with high accuracy. Figure 2 illustrates only the functionality of the computing resources in relation to the present invention. The computing resources may comprise additional systems and subsystems which are not illustrated here.

Computer arrangement 8 comprises host processor 21 with peripherals. The host processor 21 is connected to memory units 18, 19, 22, 23, 24 which store instructions and data, one or more reading units 30 (to read, e.g., floppy disks 17, CD ROM's 20, DVD's, etc.), input devices such as a keyboard 26 and a mouse 27, and output devices, such as a monitor 28 and a printer 29. Other input devices, like a trackball, a touch screen or a scanner, as well as other output devices may be provided.

An input/output (I/O) device 31 is provided for a connection to the lithographic projection apparatus.

The I/O device 31 is arranged for handling signals transmitted to and received from actuators and sensors, which take part in controlling of the projection system PL in relation to the present invention.

Further, a network I/O device 32 is provided for a connection to a network 33.

The memory units shown comprise RAM 22, (E)EPROM 23, ROM 24, tape unit 19, and hard disk 18. However, it should be understood that there may be provided more and/or other memory units known to persons skilled in the art. Moreover, one or more of them may be physically located remote from the processor 21, if required.

The processor 21 is shown as one box, however, it may comprise several processing units functioning in parallel or controlled by one main processor, that may be located remotely from one another, as is known to persons skilled in the art.

Furthermore, the computer arrangement 8 may be located remotely from the location of lithographic projection apparatus and provide its functions to the lithographic projection apparatus over a further network connection.

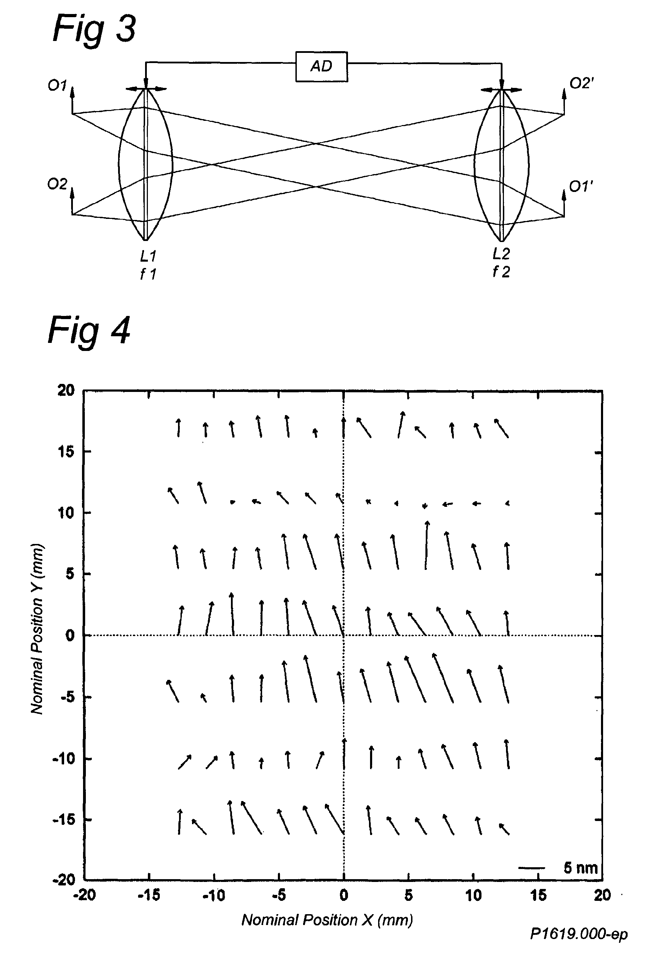

Figure 3 shows schematically a projection system PL for a lithographic projection apparatus as shown in Figure 1.

The projection system can be schematically depicted as a telescope. Such a telescope comprises as optical elements at least two lenses: a first lens L1 with a first focus f1, and a second lens L2 with a second focus f2. In this exemplary telescope the first and second lens L1, L2 are convex lenses. Persons skilled in the art will appreciate that a projection system for a lithographic projection apparatus may comprise a plurality of convex and concave lenses.

The projection system is provided with an actuating device AD which is capable of adapting the optical settings of the projection system by manipulating the optical elements within the projection system PL. The actuating device is provided with input and output ports for exchanging control signals with an control system (not shown).

In use, a first object O1 which is located in the object plane OFP is imaged as a first image IM1 on a reference plane RP. The first object O1 is a first geometrical pattern portion for forming a first feature on the substrate in the reference plane RP. The first feature typically is a (portion of ) a micro-electronic device to be formed, e.g., a transistor. Typically a transistor has a lateral size of sub-micron dimension. Accordingly, the first object has a lateral size in the mask pattern with a dimension magnified by the magnification factor M of the projection system.

Due to the (still) small finite size of the first object O1, a light beam passing the mask portion of the first object traverses only through a first limited portion of the aperture of the lenses of the projection system PL. This effect is indicated by the light paths extending from O1 towards the image IM1.

Likewise, a second object 02 is imaged as a second image IM2 on the substrate plane. In this example, the second object 02 has a size comparable to the size of the first object O1, traverses through only a second limited portion of the aperture of the lenses of projection system PL. However, due to the different location of second object in the mask pattern, the second limited portion of the projection system PL used for imaging the second object 02 is different from the first portion for imaging the first object. Since lens aberrations vary with the location on the lens, the image of first object O1 suffers from a different pattern induced distortion than the image of the second object.

It will be appreciated that the separation between the first and second object on the mask pattern influences the degree in which the suffered pattern induced distortion is different for the first and second image. When the first and second object are located at relatively close distance, the portion used of the projection system may be almost identical. At large distance, the distortion may be different (depending on local variation in the projection system) since the portions of the projection system used for creating the first and second image will be different.

Such a variation of distortion may disadvantageously occur for a first and second object within a single mask pattern. It may also occur as variation of distortion between a first and a second object which are imaged by different masks. In that case, the variation of distortion adds to the overlay error of the masks.

Figure 4 shows an exemplary map for total lens distortion of a projection system. The total lens distortion relates not only to the lens aberrations but also to reticle errors, scanning errors, etc.

As explained above, the lens aberrations cause image displacement which varies as a function of the nominal position in the image plane(and thus image distortion). A map of exemplary image displacements in the xy-plane of the image is shown as distortion field indicated by a vector representation. The direction of each vector indicates the direction of the distortion at the location of the vector, the length of each vector indicates the magnitude of the distortion at the location of the respective vector.

It is known that a geometrical distortion model can be used to describe the distortion in X- and Y-direction, i. e., *dx* and *dy*, respectively.

The geometrical distortion at each position *x, y* is defined as the deviation from the expected position (i.e. the position of the image after projection by an ideal projection system without any distortion):

$$dx = f(x, y) = T_x + M_x x + R_x y + D_3 x^3 + Rs \qquad (1)$$

$$dy = f(x,y) = T_y + M_y y + R_y x + Rs \qquad (2)$$

wherein $T_x$, $T_y$ represent a distortion offset, $M_x$, $M_y$ are linear distortion coefficients and $R_x$, $R_y$ are rotation coefficients for the x- and y-direction respectively. $D_3$ is a cubic distortion coefficient. $Rs$ is a residual term.

It is noted that $T_x$, $T_y$, $M_x$, $M_y$, $R_x$, $R_y$, and $D_3$ are geometry-related coefficients which can be adapted by the projection system by a change of settings for respective optical elements within the projection system to change a

EP 1 496 397 A1

geometry of an image of an object.

Additional to the distortions of eq. 1 and eq. 2, which reflect low-order lens aberrations, also distortions caused by high-order lens aberrations exist.

Typically, low-order lens aberrations relate to distortion effects which are independent of the optical path of the image, whereas high-order lens aberrations relate to distortion effects which depend on the actually used optical path of the image in the lens system.

The interaction between the shape and size of features in a mask pattern, the illumination mode of the projection system and distortion due to higher order lens aberrations generate a pattern induced distortion of features.

Lens aberrations are commonly described by Zernike coefficients, which each relate to a specific type of aberration. The description of lens aberrations by Zernike coefficients is well known to persons skilled in the art and will not be explained in more detail here.

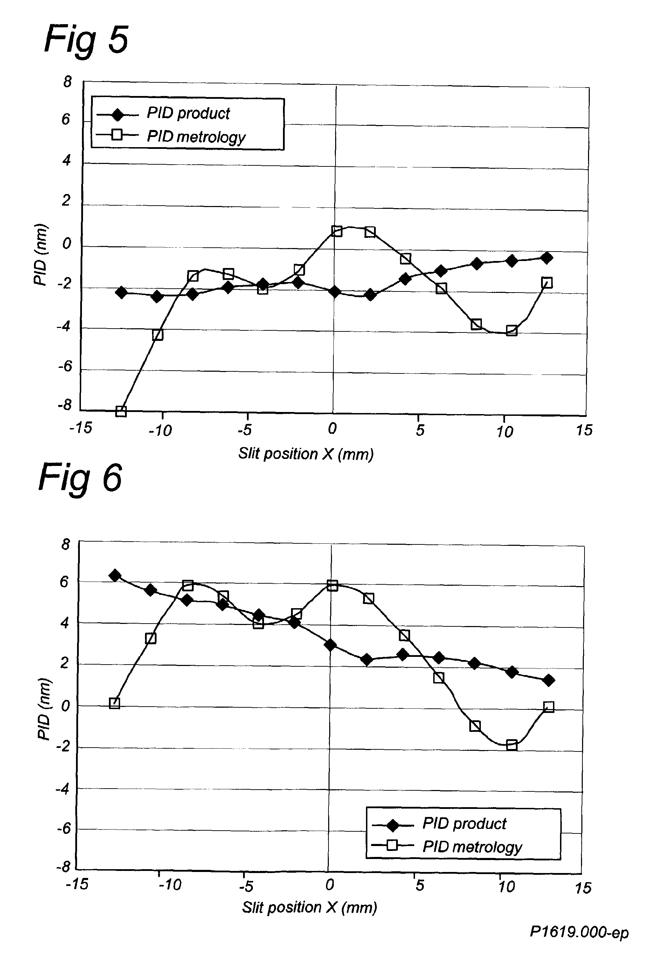

Figure 5 shows exemplary pattern induced distortion data for product and overlay metrology features as measured.

For a lithographic projection apparatus which applies an imaging process by scanning a slit across a mask, an average distortion across the slit can be obtained from the data of Figure 4. The slit extends in the X-direction, and the scanning direction is in the Y-direction.

In Figure 5 the average distortion $dx$ of a relatively small-sized object (i.e., a product feature) in the x-direction is plotted by a line with solid diamonds as a function of the scanning direction $y$. Further, the distortion $dx_{ov}$ of an overlay structure, which is relatively large-sized is plotted in Figure 5 as a line with open squares. It is noted that no overlay correction has been applied.

From Figure 5 it is clear that pattern induced distortion is dependent on the size of the object being imaged. The pattern induced distortion of a small-seized object in this case differs from the distortion of the relatively larger object.

Figure 6 shows the pattern induced distortion data of Figure 5 for product and overlay metrology features after applying a metrology-based correction.

In Figure 6 the lines with the same symbols refer to the same entities as shown in the preceding figure 5.

In this example from the prior art, a correction of the overlay of product features based on the distortion measured for the overlay marker $(dx_{ov})$ by taking the linear difference between the two outer values of $dx_{ov}$ will be incorrect. Basically, such a correction is based on a translation and/or a magnification of the image. As shown in this example, the corrected overlay for the product features will be worse than the uncorrected product feature overlay, in spite of the fact that the overlay of the overlay structure itself is improved. The outer edges of the overlay structure have a pattern induced distortion of substantially zero (in the shown x-direction).

In the present invention, the pattern induced distortion of a feature to be imaged is minimised as a function of the distortion caused by the illumination mode and lens aberrations that contribute to the distortion for that particular feature. Also, the influence of surrounding features (on the mask) and their density can be taken into account.

The computer arrangement 8 of the present invention is capable of controlling and adjusting the settings of the projection system in such a way that during an exposure the overlay displacement of features is as low as possible.

To this end, the computer arrangement 8 uses information derived from mask pattern data, from data on high-order lens aberrations and from the resulting parameter values ($T_x$, $T_y$, $M_x$, $M_y$, $R_x$, $R_y$, and $D3$) of eq. 1 and eq. 2. The mask pattern data relate to data which describe the pattern of features on the imaging mask. The lens aberration data are derived from measurements performed on the projection lens of the lithographic projection apparatus.

The processor 21 is capable to perform computations on the mask pattern data, and on the data on high-order lens aberrations and to perform, based on these computations and on the parameter values ($T_x$, $T_y$, $M_x$, $M_y$, $R_x$, $R_y$, and $D3$) of eq. 1 and eq. 2, corrections of the settings of the projection system to minimize the pattern induced distortion for the given mask pattern.

Below, the procedure for these computations will be explained in more detail.

As a first step, the lens aberrations measured for the projection system need to be described, for example, in terms of Zernike coefficients.

Next, an aerial image of a given mask pattern is calculated. A diffraction model is used to compute an ideal aerial image, free of any pattern induced distortion, and also a deformed (projection of the) aerial image for the given pattern with distortion due to aberrations (Zernike coefficients).

Finally, for each co-ordinate of the 'projected' aerial image the local distortion ($dx$, $dy$) at each co-ordinate is derived, by determining the deviation between the ideal image and the deformed image of the mask pattern.

The implementation of correcting the aerial image for pattern induced distortion can be achieved in various ways:

- Since the image can be modified at each co-ordinate by adapting the machine parameters which correct the geometrical distortion coefficients $T_x$, $T_y$, $M_x$, $M_y$, $R_x$, $R_y$ and $D3$, a full computation of the machine settings at each co-ordinate is performed. This requires a comprehensive computation/simulation method on high-end hardware. The resulting imaging correction data for the geometrical distortion coefficients $T_x$, $T_y$, $M_x$, $M_y$, $R_x$, $R_y$, and $D3$ from this computation can be used to adapt the settings of the projection system at each co-ordinate of the image during the processing run of the lithographic projection apparatus. The computation may be executed before or during the processing run.

If the computation is done before the processing run, the imaging correction data will be stored in the memory of the computer arrangement 8, and will be retrieved during the processing run and used to adapt the projection system by an on-line adaptation procedure which adapts the projection system settings during the processing run in accordance with the parameters for pattern induced distortion as given by equations (1) and (2). Alternatively, the computation and the adaptation of the projection system (based on the results of the computation) are done in real-time.

- Secondly, a linear estimation computation model can be used that implements an adaptation of projection system settings based on a linear combination of the sensitivity of distortion of an image with respect to each of the Zernike coefficients. Basically, a distortion of an ideal pattern feature with a given ideal centroid position will relatively shift the centroid position. For each type of distortion as defined by the Zernike coefficients, the sensitivity to distortion for a given pattern feature will differ, but can be calculated based on a distortion map as shown in Figure 3 or 4, depending on a "co-ordinate by co-ordinate" or "slit co-ordinate" based approach, respectively.

Furthermore, the sensitivity for a given distortion type varies with the shape of the (basic) pattern feature to be imaged.

Therefore, the linear estimation computation model computes (for example in an off-line mode), the pattern induced distortion parameters for a variety of pattern features (variation of shape and size) in combination with the local lens aberrations of the projection system. Also, the illumination mode and mask type (i.e., the pupil plane filling) is taken into account.

Using the linear estimation computation model the distortion *(dx, dy)* on a co-ordinate *(x, y)* is described by:

$$dx(x,y) = \sum_{i=7,10,14,...} Z_i(x,y) \cdot S_i \qquad (3)$$

$$dy(x,y) = \sum_{i=8,11,15,...} Z_i(x,y) \cdot S_i \qquad (4)$$

where $Z_i$ is a Zernike coefficient of $i^{th}$ order,
$S_i$ is a sensitivity coefficient for a given Zernike coefficient $Z_i$, with the x-distortion and the y-distortion each being described by a series of Zernike coefficients.
The Zernike coefficients depend on the x, y coordinate. The sensitivities $S_i$ basically depend on the pattern, and the illumination mode.

The results of these computations of eq. 3 and eq. 4 are stored in memory of the computer arrangement 8 in one or more data-bases as imaging correction data. The imaging correction data can be determined for any given combination of pattern feature type and size, and pupil plane filling. The one or more databases may hold imaging correction data as a function for each of such combinations.

During the lithographic processing run, the imaging correction data are retrieved from the memory. The projection system settings are adapted in accordance with a combination of pattern distortion parameters: the type and size of the pattern feature to be imaged, the actual lens aberrations co-ordinate and the actual pupil plane filling for that pattern feature.

The imaging correction data (based on the combination of actual pattern distortion parameters) can be made available from the data-base through information in the job data file for the processing run to an on-line adaptation procedure. The on-line adaptation procedure adapts, by means of I/O device 31, the projection system settings during the processing run in accordance with the imaging correction parameters for pattern induced distortion as given by equations (3) and (4).

This approach may be advantageous in circumstances where a user of an lithographic projection apparatus equipped with the system and method according to the present invention intends to have a minimal interaction between equipment and processing personnel.

- A further alternative is a combination of a comprehensive computation and a linear estimation. This approach is advantageous for situations where the linear estimation model suffers from too large an inaccuracy. Such a situation may occur in some cases (i.e., combinations of the type and size of the pattern feature to be imaged, the actual lens aberrations co-ordinate and the actual pupil plane filling for that pattern feature) where appreciable cross-terms may exist between various Zernike coefficients. This may, for example, occur for some critical parts in certain patterns with certain combinations of pattern features. This last alternative may initially run as a linear estimation computation as described above, but for a critical part of a given combination of pattern, lens aberrations and pupil plane filling where one or more appreciable cross-terms are expected, a comprehensive computation is performed for that particular critical part.

Again, during the processing run the combination of actual imaging correction parameters can be made available from the data-base through information in the job data file for the processing run to an on-line adaptation procedure. The on-line adaptation procedure adapts the projection system settings during the processing run in accordance with the imaging correction parameters for pattern induced distortion as given by equations sets (1), (2) and/or (3), (4).

The implementation of correcting the aerial image for pattern induced distortion and the on-line adaptation procedure are carried out by the computer arrangement 8 of the electronic control system. The computations are performed by the processor 21. Data relating to correction parameters for the projection system are stored in memory units of the computer arrangement. The processor 21 determines the imaging correction parameters and instructs the I/O device 31 to transmit imaging correction signals to the actuating device AD of the projection system which comprises sensors and actuators for correcting the pattern induced distortion during the processing run.

It is noted that the electronic control system 8 may receive status signals from the lithographic projection apparatus which relate to the status and /or the settings of the projection system and/or other parts of the lithographic projection apparatus. As will be appreciated by persons skilled in the art, the status signals may influence the timing and/or response of the electronic control system. These signals are however not discussed here.

**Claims**

1. Method for modifying an aerial image of a pattern during an imaging process, said pattern being arranged on a mask for imaging by a projection system on a surface,
   said aerial image being an image formed from said pattern by a portion of said projection system,
   an imaging quality of said portion of said projection system being described by imaging quality parameters,
   **characterised in that**
   said projection system is arranged for adjusting a geometry of said aerial image by image adjustment parameters for said portion of said projection system,
   and said method comprises:

   - determining an ideal aerial image for said pattern;
   - determining a simulated distorted aerial image for said pattern based on said imaging quality parameters;
   - determining a deviation between said simulated distorted image and said ideal image;
   - adapting said image adjustment parameters during said imaging process to minimise said deviation between said simulated distorted image and said ideal image.

2. Method according to claim 1, **characterised in that**
   said imaging quality parameters describe low-order lens aberrations which relate to first distortion effects for said aerial image which are independent of an optical path in the projection system,
   and said imaging quality parameters describe high-order lens aberrations which relate to second distortion effects for said aerial image which depend on actually taken optical path in the projection system.

3. Method according to claim 1 or 2, **characterised in that**
   said adapting said image adjustment parameters comprises a determination of geometrical distortion coefficients at each co-ordinate of said aerial image as image correction data by:

   - calculating settings for respective optical elements within said projection system to obtain a substantially distortion-free geometry of said aerial image,

said image correction data being used as image adjustment parameters for adjusting said projection system at each respective co-ordinate of said aerial image.

4. Method according to claim 1, **characterised in that**
said adapting said image adjustment parameters comprises a determination of geometrical distortion coefficients at each co-ordinate of said aerial image as image correction data by:

- estimating for each aberration type as defined by a respective Zernike coefficient, a sensitivity of an image feature for distortion with respect to said respective Zernike coefficient,
- determining a first linear combination of said sensitivity for each aberration type in a first direction in said aerial image, and
- determining a second linear combination of said sensitivity for each aberration type in a second direction in said aerial image, said second direction being substantially perpendicular to said first direction,
said image correction data being used as image adjustment parameters for adjusting said projection system at each respective co-ordinate of said aerial image.

5. Method according to any one of the preceding claims, **characterised in that** said co-ordinate of said aerial image is determined as "co-ordinate-by-co-ordinate" during a lithographic process in a step-and-repeat mode.

6. Method according to any one of the preceding claims 1 - 5, **characterised in that** said co-ordinate of said aerial image is determined as "slit-co-ordinate" during a lithographic process in a step-and-scan mode.

7. System for modifying an aerial image of a pattern during an imaging process, said system comprising a mask, a projection system, and an electronic control system;
said system (8) being capable of controlling and adjusting machine parameters during execution of an imaging and exposure process and comprising a host processor (21), memory (18, 19,22, 23, 24) storing instructions and data, and an input/output device (31) for handling signals transmitted to and received from actuators and sensors in said projection system, said host processor being connected to said memory (18, 19,22, 23, 24) for processing on said instructions and data and to said input/output device (31) for controlling said signals handled by said input/output device (31);
said pattern being arranged on said mask for imaging by said projection system on a surface,
said aerial image being an image formed from said pattern by a portion of said projection system,
an imaging quality of said portion of said projection system being described by imaging quality parameters,
**characterised in that**,
in use,
said projection system is arranged for adjusting a geometry of said aerial image formed by image adjustment parameters for said portion of said projection system,
and said electronic system is capable of performing:

- determining an ideal aerial image for said pattern;
- determining a simulated distorted aerial image for said pattern based on said imaging quality parameters;
- determining a deviation between said simulated distorted image and said ideal image;
- adapting said image adjustment parameters during said imaging process to minimise said deviation between said simulated distorted image and said ideal image.

8. Computer program product to be loaded by a system in accordance with claim 7 for modifying an aerial image of a pattern during an imaging process;
said system comprising a mask, a projection system, and an electronic control system;
said electronic control system (8) being capable of controlling and adjusting machine parameters during execution of an imaging and exposure process and comprising a host processor (21), memory (18, 19,22, 23, 24) storing instructions and data, and an input/output device (31) for handling signals transmitted to and received from actuators and sensors in said projection system, said host processor being connected to said memory (18, 19,22, 23, 24) for processing on said instructions and data and to said input/output device (31) for controlling said signals handled by said input/output device (31);
**characterised in that**
said computer program product after being loaded allows said host processor (21) to carry out:

- determining an ideal aerial image for said pattern;

- determining a simulated distorted aerial image for said pattern based on said imaging quality parameters;
- determining a deviation between said simulated distorted image and said ideal image;
- adapting said image adjustment parameters during said imaging process to minimise said deviation between said simulated distorted image and said ideal image.

9. A data carrier with a computer program product as claimed in claim 8.

10. Lithographic projection apparatus comprising:

- a radiation system for providing a projection beam of radiation;
- a support structure for supporting patterning means, the patterning means serving to pattern the projection beam according to a pattern;
- a substrate table (WS) for holding a substrate;
- a projection system for projecting the patterned beam onto a target portion of the substrate;
   said pattern being arranged in said patterning means on a mask for imaging by a projection system on a surface,
   said aerial image being an image formed from said pattern by a portion of said projection system,
   an imaging quality of said portion of said projection system being described by imaging quality parameters,

**characterised in that**,
in use,
said projection system is arranged for adjusting a geometry of said aerial image by image adjustment parameters for said portion of said projection system,
and said lithographic projection apparatus is arranged to perform:

- determining an ideal aerial image for said pattern;
- determining a simulated distorted aerial image for said pattern based on said imaging quality parameters;
- determining a deviation between said simulated distorted image and said ideal image;
- adapting said image adjustment parameters during said imaging process to minimise said deviation between said simulated distorted image and said ideal image.

# Fig 1

# Fig 2

*Fig 3*

*Fig 4*

P1619.000-ep

## Fig 5

## Fig 6

P1619.000-ep

**EP 1 496 397 A1**

---

| | | | |
|---|---|---|---|
| **European Patent Office** | **EUROPEAN SEARCH REPORT** | | **Application Number**<br>EP 03 07 7204 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 246 014 A (ASML NETHERLANDS BV) 2 October 2002 (2002-10-02) * abstract; claims 1,17,24,26,27 * * paragraphs [0006], [0007] * * paragraph [0012] - paragraph [0019] * * paragraph [0028] - paragraph [0038] * ----- | 1-10 | G03F7/20 |
| X | VAN DER LAAN H ET AL: "Aerial image measurement methods for fast aberration set-up and illumination pupil verification" PROC. SPIE - INT. SOC. OPT. ENG. (USA), PROCEEDINGS OF THE SPIE - THE INTERNATIONAL SOCIETY FOR OPTICAL ENGINEERING, 2001, SPIE-INT. SOC. OPT. ENG, USA, vol. 4346, pt.1-2, 27 February 2001 (2001-02-27), pages 394-407, XP008025417 ISSN: 0277-786X * page 394 - page 397 * * pages 402,406 * ----- | 1-10 | |
| X | US 2003/047694 A1 (VAN DER LAAN HANS) 13 March 2003 (2003-03-13) * paragraph [0013] - paragraph [0022] * * paragraph [0050] * * paragraph [0060] - paragraph [0068] * * claim 16; figures 6-8 * ----- | 1,7-10 | TECHNICAL FIELDS SEARCHED (Int.Cl.7)<br>G03F |
| X | EP 1 164 436 A (ASM LITHOGRAPHY BV) 19 December 2001 (2001-12-19) * claims 1,17; table 1 * * paragraph [0017] - paragraph [0021] * ----- | 1,7-10 | |

The present search report has been drawn up for all claims

| Place of search | Date of completion of the search | Examiner |
|---|---|---|
| Munich | 18 June 2004 | Hagner, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                EP 03 07 7204

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2004

| Patent document cited in search report | | Publication date | Patent family member(s) | | Publication date |
|---|---|---|---|---|---|
| EP 1246014 | A | 02-10-2002 | EP | 1246014 A1 | 02-10-2002 |
| | | | EP | 1251402 A1 | 23-10-2002 |
| | | | JP | 2002334835 A | 22-11-2002 |
| | | | TW | 512427 B | 01-12-2002 |
| | | | US | 2002191165 A1 | 19-12-2002 |
| US 2003047694 | A1 | 13-03-2003 | EP | 1286223 A1 | 26-02-2003 |
| | | | JP | 2003158071 A | 30-05-2003 |
| EP 1164436 | A | 19-12-2001 | EP | 1164436 A2 | 19-12-2001 |
| | | | JP | 2002015997 A | 18-01-2002 |
| | | | TW | 500987 B | 01-09-2002 |
| | | | US | 2002036758 A1 | 28-03-2002 |

EPO FORM P0459

For more details about this annex : see Official Journal of the European Patent Office, No. 12/82